# EUROPÄISCHE PATENTSCHRIFT

(11) **EP 2 035 326 B1**
(45) Veröffentlichungstag und Bekanntmachung des Hinweises auf die Patenterteilung: **15.06.2011**
(21) Anmeldenummer: 07728389.3
(22) Anmeldetag: 23.04.2007
(51) Int. Cl.: B81B 3/00, G01J 5/10, G01K 7/01

(54) **SENSOR MIT DIODENPIXELN UND VERFAHREN ZU SEINER HERSTELLUNG**
SENSOR HAVING DIODE PIXELS AND METHOD FOR PRODUCING THE SAME
CAPTEUR AYANT DES PIXELS A DIODES ET PROCÉDÉ DE FABRICATION DUDIT CAPTEUR

(30) Priorität: 21.06.2006 DE 102006028435
(43) Veröffentlichungstag der Anmeldung: 18.03.2009
(73) Patentinhaber: Robert Bosch GmbH, 70442 Stuttgart (DE)
(72) Erfinder: BENZEL, Hubert, 72124 Pliezhausen (DE); ARMBRUSTER, Simon, 72810 Gomaringen (DE); SCHELLING, Christoph, 70597 Stuttgart (DE); HOECHST, Arnim, 72074 Tuebingen (DE); FEYH, Ando, 71732 Tamm (DE)
(86) Internationale Anmeldenummer: PCT/EP2007/053932
(87) Internationale Veröffentlichungsnummer: WO 2007/147663

(56) Entgegenhaltungen:
- WO-A-03/011747
- DE-A1- 10 114 036
- DE-A1- 10 246 050
- DE-A1- 10 326 787
- DE-A1- 10 330 610
- DE-A1-102004 043 357
- DE-C1- 4 418 207

## Beschreibung

Die Erfindung betrifft einen Sensor, insbesondere zur ortsaufgelösten Detektion, und ein Verfahren zu seiner Herstellung.

### Stand der Technik

Die DE 101 14 036 A1 zeigt ein Verfahren zur Herstellung von mikrostrukturierten Sensoren, bei dem in ein Halbleitersubstrat Öffnungen eingebracht werden, die sich bei einer nachfolgenden Temperaturbehandlung in der Tiefe des Substrates zu Hohlräumen unter einer geschlossenen Membrandecke wandeln. Hierdurch kann ein kapazitiver Drucksensor hergestellt werden, wobei der Hohlraum im Substrat zwischen zwei Dotierungszonen erzeugt wird, die einen Plattenkondensator mit einer vom Abstand der Dotierungszonen abhängigen Kapazität bilden. Die Dotierungszonen werden durch Tiefenkontaktierung mit einer entsprechenden Auswerteschaltung verbunden.

Die DE 10 2004 043 357 A1 zeigt ein Verfahren zur Herstellung eines Hohlraums in einem Halbleitersubstrat, bei dem an der Oberfläche des Substrates zunächst eine gitterartige Struktur aus nicht porös geätztem Substratmaterial erzeugt wird, zwischen bzw. unterhalb von der nachfolgend in die Tiefe des Halbleitersubstrats ein poröser Bereich erzeugt wird. Durch eine nachfolgende Temperaturbehandlung wird der porosifizierte Bereich zu einer Kaverne umgelagert, wobei gegebenenfalls die gitterartige Struktur zu einer Membran oder als Teil einer Membran oberhalb der Kaverne ausgebildet wird.

Die DE 102 46 050 A1 beschreibt die Herstellung eines Feuchtesensors dessen Sensorelement in einer Halbleitermembran oberhalb eines Hohlraums angeordnet ist. Dieser Hohlraum wird durch poröses Ätzen in einem Halbleitersubstrat geschaffen.

Derartige Herstellungstechniken ermöglichen jedoch oftmals nicht die Ausbildung komplexerer Sensoren mit hoher Auflösung und geringem Rauschen.

### Offenbarung der Erfindung

Der erfindungsgemäße mikrostrukturierte Sensor und das Verfahren zu seiner Herstellung weisen demgegenüber einige Vorteile auf. Hierbei werden in einem Substrat mehrere lateral beabstandete Sensorelemente ausgebildet, die jeweils unterhalb einer Membran aus dielektrischem Material aufgehängt sind. Die Sensorelemente sind Dioden pixel. grundsätzlich z. B. auch Transistoren sein. Relevant ist, dass die einzelnen Sensorelemente jeweils eine temperaturabhängige elektrische Eigenschaft haben, deren Werte über Zuleitungen ausgelesen werden können. In einem nicht zur Erfindung gehörenden Beispiel könnten sie jedoch.

Die einzelnen Sensorelemente sind in einer oder mehreren unterhalb der Membran ausgebildeten Kavernen aufgehängt. Hierbei kann für jedes Sensorelement eine einzelne Kaverne vorgesehen sein oder mehrere oder alle Sensorelemente können in einer gemeinsamen Kaverne angeordnet werden.

Die einzelnen Sensorelemente sind über Zuleitungen kontaktiert, die in, auf oder unter der Membran verlaufen. Hierbei kann die Membran insbesondere derart strukturiert werden, dass sie einzelne Aufhängefedern ausbildet, die jedes Sensorelement an dem umgebenen Festland bzw. umgebenen Stegen einer auf oder oberhalb des Substrats ausgebildeten epitaktischen Schicht anbinden.

Gemäß einer bevorzugten Ausführungsform werden in der die Membran bildenden dielektrischen Schicht Verstärkungen, insbesondere durch eine lokale Oxidation erzeugte LOCOS-(local oxidation of silicon) Verstärkungen ausgebildet, die die mechanische Stabilität deutlich erhöhen. Die Verstärkungen können insbesondere am lateralen Rand der Membran ausgebildet werden, so dass sie das jeweilige Sensorelement umgeben; weiterhin können sie am lateralen Rand des Festlandes bzw. verbleibender, die Sensorelemente tragender Stege verlaufen und somit die Aufhängefedern mit hoher Festigkeit aufnehmen. Hierdurch kann die Bruchfestigkeit der Aufhängefedern an den Sensorelementen und dem Festland bzw. den verbleibenden Stegen erhöht werden.

Durch die Membran, insbesondere durch die Aufhängefedern in der Membran, wird eine sehr gute thermische Entkopplung der Sensorelemente voneinander und vom Festland erreicht. Indem die Sensorelemente in einer epitaktischen und somit monokristallinen Schicht ausgebildet werden, kann das Signalrauschen sehr gering gehalten werden. Dies ist insbesondere bei Ausbildung von Dioden oder Transistoren vorteilhaft.

Somit wird ein Bauelementearray mit hoher Auflösung bzw. hoher Anzahl von Sensorelementen und geringem Rauschen gebildet, das mechanisch sehr stabil ausgebildet werden kann. Die einzelnen Zuleitungen zu den Sensorelementen können an gemeinsame Zuleitungen angeschlossen werden, so dass die einzelnen Bauelemente über eine sukzessive Adressierung ausgelesen werden können. Durch die hohe Integration ist eine geringe Leistungsaufnahme erforderlich.

Es kann insbesondere ein Diodenarray zur ortsaufgelösten Temperaturmessung und/oder spektroskopischen Messung einer Gaskonzentration ausgebildet werden. Ein weiteres Anwendungsgebiet ist ein Fingerabdrucksensor.

Gemäß einer bevorzugten Ausführungsform weist der Sensor nicht nur den Detektorbereich mit den Sensorelementen, sondern lateral angrenzend und von diesem vorteilhafterweise isoliert einen Schaltungsbereich mit weiteren Bauelementen zur Auswertung der von den Sensorelementen ausgegebenen Signale auf. Hierbei können zumindest einige der Prozessschritte der Ausbildung der Sensorelemente des Detektorbereichs auch zur Ausbildung des Schaltungsbereichs herangezogen werden, so dass eine schnelle und kostengünstige Herstellung möglich ist. Somit kann ein MEMS-(Micro Electro Mechanical System)- Bauelement mit kombinierter Sensorik und elektronischer Auswerteschaltung auf einem Chip ausgebildet werden.

Die Herstellung kann vollständig durch oberflächenmikromechanische Prozessschritte erfolgen, so dass lediglich eine Oberfläche zu bearbeiten ist. Die Herstellung kann hierbei auf Wafer-Ebene mit nachfolgender Vereinzelung durchgeführt werden.

Zur Herstellung wird zunächst ein erster Bereich des dotierten Substrates (bzw. einer auf dem Substrat ausgebildeten dotierten Schicht) porosifiziert, wobei zunächst eine gitterartige Struktur und ein den ersten Bereich umgebender zweiter Bereich durch eine geeignete Dotierung vor dem nachfolgenden Ätzvorgang geschützt werden. Der erste Bereich unterhalb der gitterartigen Struktur kann somit nachfolgend selektiv elektrolytisch porosifiziert werden, wobei gegebenenfalls auch bereits eine vollständige Entfernung des Materials in diesem Bereich erreicht werden kann. Nachfolgend kann auf der gitterartigen Struktur und dem umgebenden Festland eine epitaktische Schicht aufgewachsen werden, wobei während des Aufwachsens (oder gegebenenfalls auch in einem zusätzlichen Schritt) eine Temperung des porösen Bereiches unter Ausbildung einer Kaverne erreicht wird.

Somit kann oberhalb der Kaverne eine epitaktische monokristalline Schicht ausgebildet werden, in der nachfolgend die Sensorelemente durch weitere Prozessschritte, z. B. durch Dotierung entsprechender Diodenbereiche, ausgebildet werden. Da die Sensorelemente in der monolithischen epitaktischen Schicht ausgebildet sind, weisen sie ein geringes Signalrauschen auf. Durch die Kaverne sind sie bereits vom Substrat thermisch isoliert.

Eine weitere Isolierung wird durch Ausbildung einer Membran erreicht, unterhalb der die Sensorelemente aufgehängt sind. Hierzu wird auf der epitaktischen Schicht eine (oder mehrere) dielektrische Schichten aufgetragen und nachfolgend strukturiert. Die dielektrische Schicht kann insbesondere durch Oxidation oder Auftragen einer Oxidschicht, Ausbildung von Ätzzugängen durch die dielektrische Schicht und die epitaktische Schicht sowie nachfolgendes Opferschichtätzen der epitaktischen Schicht ausgebildet werden. Die mindestens eine dielektrische Schicht bildet somit eine oberhalb der Kaverne freitragende Membran, die das jeweilige Sensorelement thermisch und mechanisch entkoppelt aufnimmt. Durch Strukturierung von Aufhängefedern in der Membran kann eine weitere thermische Entkopplung erreicht werden, wobei dann die elektrischen Zuleitungen zu den Sensorelementen über die Aufhängefedern geführt werden können.

### Kurze Beschreibung der Zeichnungen

Die Erfindung wird im Folgenden anhand der beiliegenden Zeichnungen an einigen Ausführungsformen näher erläutert. Es zeigen:
- Fig. 1a bis f: die Prozessschritte der Herstellung eines mikromechanischen Sensors gemäß einer ersten Ausführungsform exemplarisch für ein Diodenpixel des Sensors:

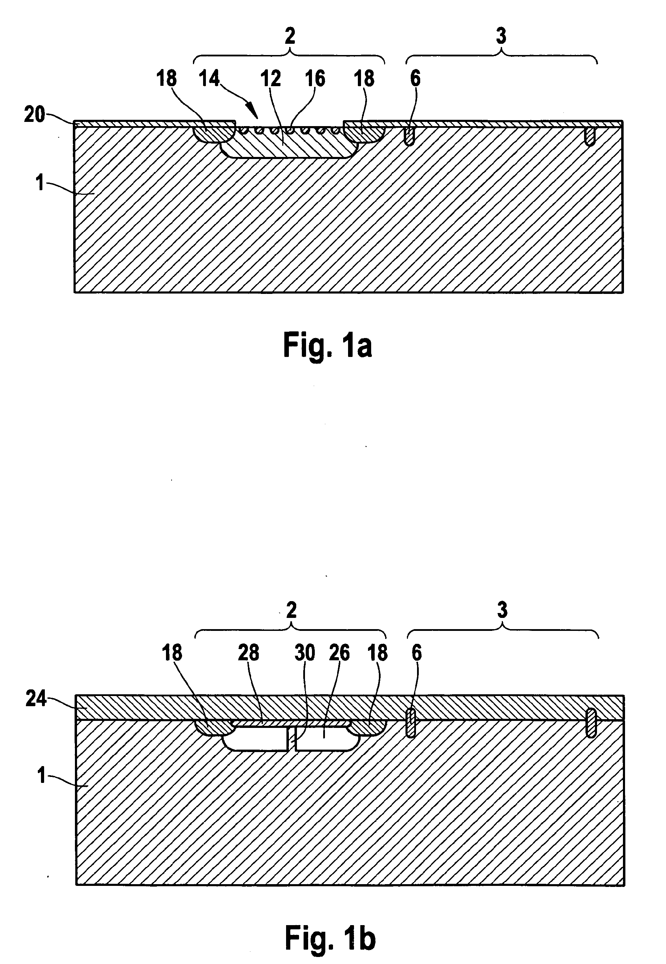

- Fig. 1a: einen Schaltungsvorprozess und einen Prozessschritt der Ausbildung einer Gitterstruktur im Detektorbereich;
- Fig. 1 b: den Prozessschritt der Epitaxie einer n-Schicht;
- Fig. 1c: die Prozessschritte der Implantation bzw. Diffusion im Schal- tungsbereich, Erzeugung dielektrischer Schichten und Struktu- rierung der Kontaktlöcher in den dielektrischen Schichten;
- Fig. 1d: den Backend-Schaltungsprozess unter Ausbildung einer ganz- flächigen Metallbedeckung der Membran und von Passivie- rungsschichten im Schaltungsbereich;
- Fig. 1e: die Prozessschritte der Entfernung des Schichtstapels ober- halb der ersten Metallisierungsschicht, Strukturierung der Me- tallisierung im Bereich der Diodenpixel und Öffnung von Op- ferschichtätzzugängen bzw. Aufhängefedern in der verblei- benden dielektrischen Schicht;
- Fig. 1f: das isotrope Opferschichtätzen zur Freilegung des Diodenpi- xels;
- Fig. 2: eine zu Fig. 1f alternative Ausführungsform bei nachträglicher Ausbildung einer Kaverne von der Rückseite her;
- Fig. 3: eine Draufsicht auf ein fertig gestelltes Diodenpixel gemäß Fig. 1f oder Fig. 2;
- Fig. 4: ein Querschnitt durch einen Sensor mit mehreren Diodenpi- xeln und durchgängigem, gemeinsamen Freiraum;
- Fig. 5: eine Draufsicht auf den Sensor der Fig. 4 mit mehreren Dio- denpixeln.

### Ausführungsformen der Erfindung

In dem Herstellungsprozess wird auf einem p-Halbleitersubstrat 1, z.B. p-dotiertem (100) Silizium, ein Detektorbereich 2 und lateral beabstandet bzw. angrenzend ein Schaltungsbereich 3 ausgebildet, wobei die Ausbildung der beiden Bereiche 2, 3 in den nachfolgenden Prozessschritten ganz oder teilweise kombiniert sein kann.

Gemäß den Figuren 1a bis 1f erfolgt die Ausbildung sowohl des Schaltungsbereichs 3 als auch des Detektorbereichs 2 oberflächenmikromechanisch von der Oberseite des p-Substrates 1 aus. Hierbei können zur Ausbildung des Schaltungsbereichs 3 zunächst Schaltungsvorprozesse durchgeführt werden. Auch zwischen den nachfolgenden Prozessschritten 1a bis 1f können jeweils Prozessschritte zur Ausbildung des Schaltungsbereichs 3 ergänzt werden. Vorteilhafterweise werden ein oder mehrere der nachfolgenden Prozessschritte zur Ausbildung des Detektorbereichs 3 gleichzeitig zur Herstellung des Schaltungsbereichs 3 verwendet.

In dem p-Substrat 1 kann zwischen dem Detektorbereich 2 und dem Schaltungsbereich 3 durch z. B. p⁺-Dotierung eine im Querschnitt grabenförmige untere Iso-Schicht 6 ausgebildet werden, die in einem späteren Prozessschritt nach oben ergänzt wird und der Isolierung des Detektorbereichs 2 von dem Schaltungsbereich 3 dient.

Im Detektorbereich 2 wird für jedes der herzustellenden Sensorelemente ein erster Bereich 12 porosifiziert, wobei eine gitterartige Struktur 14 mit Gitterstegen 16 auf der Oberseite des ersten Bereichs 12 ausgespart wird. Der erste Bereich 12 wird vorteilhafterweise in lateraler Richtung durch einen ringförmigen zweiten Bereich 18 begrenzt. Der erste Bereich 12 und der zweite Bereich 18 sind unterschiedlich dotiert, insbesondere mit einem unterschiedlichen Ladungsträgertyp. Hierbei ist der erste Bereich 12 z.B. p-dotiert, d.h. er kann insbesondere direkt aus dem p-Substrat 1 ausgebildet werden, und der zweite Bereich 18 n⁺ (oder auch n) - dotiert. Grundsätzlich kann der erste Bereich 12 auch bereits vollständig entfernt werden, so dass als "100 %ige Porosität" unterhalb der gitterartigen Struktur 14 ein Freiraum verbleibt.

Die Herstellung dieser Anordnung eines porosifizierten ersten Bereichs 12, eines umgebenden zweiten Bereichs 18 und einer ausgesparten gitterartigen Struktur 14 ist z.B. in der DE 10 2004 036 035 A1 sowie der DE 100 32 579 A1 beschrieben, worauf hier für einzelne Details verwiesen wird. Der zweite Bereich 18 wird am lateralen Rand des ersten Bereichs 12 z.B. durch Umdotierung, z.B. mittels Verfahren zur Implantation und/oder Diffusion erzeugt. Weiterhin wird die gitterartige Struktur 14 mit den Gitterstegen 16 durch n-Dotierung und die untere Iso-Schicht 6 durch p⁺⁻ Dotierung ausgebildet. Diese Ausbildungen des zweiten Bereichs 18, der gitterartigen Struktur 14 und der unteren Iso-Schicht 6 kann z. B. mittels Lackmasken vor den weiteren Prozessschritten, d.h. auch vor dem Ätzen, erfolgen.

Auf den Detektorbereich 2 und der Schaltungsbereich 3 wird nachfolgend eine Ätzmaske 20 aus z. B. SiO2 und/oder Si3N4 aufgetragen und so strukturiert, dass sie den ersten Bereich 12 mit der gitterartigen Struktur 14 ausspart. Dann wird der erste Bereich 12 durch elektrochemisches Ätzen in einem flusssäurehaltigen Elektrolyten porosifiziert. Hierbei kann zur Herabsetzung der Oberflächenspannung ein Netzmittel hinzugefügt werden, z.B. Isopropanol, Ethanol oder ein Tensid. Je nach Substratdotierung und gewünschter Mikrostruktur kann die Konzentration an Flusssäure im Bereich zwischen 10 und 50 % betragen. Die Porosität des ersten Bereichs 12 kann durch Wahl der Stromdichte eingestellt werden.

Die Gitterstege 16 und der ringförmige, n⁺-dotierte zweite Bereich 18 werden durch den elektrochemischen Ätzprozess nicht angegriffen, da für den Auflösungsvorgang von Silizium Löcher (Defektelektronen) erforderlich sind, welche im p-Silizium in ausreichender Form zur Verfügung stehen, nicht jedoch im n-Si. Der zweite Bereich 18 begrenzt somit den ersten Bereich 12 in lateraler Richtung, die Tiefe des ersten Bereichs 12 wird durch die Ätzdauer und Stromstärke festgelegt.

Gemäß Fig. 1b wird nachfolgend eine n-Epi-Schicht 24 epitaktisch auf das p-Substrat 1 aufgetragen bzw. aufgewachsen, die sich über den Detektorbereich 2 und den Schaltungsbereich 3 erstreckt. Bei diesem epitaktischen Aufwachsen erfolgt auch eine Temperung des porösen ersten Bereichs 12, der zu einer thermischen Umlagerung des porösen Materials und somit zur Ausbildung einer Kaverne 26 unterhalb der n-Epi-Schicht 24 führt. Aus dem porösen Material scheidet sich hierbei im allgemeinen eine monokristalline Schicht an den Wänden der Kaverne 26 ab. Die Gitterstege 16 lagern sich z. B. zu einer monokristallinen Schicht 28 zwischen der Kaverne 26 und der n-Epi-Schicht 24 um. Dieser Temperschritt kann z.B. bei ca. 900 bis 1200 °C durchgeführt werden. Die Ausbildung einer Kaverne 26 aus einem porösen Bereich ist hierbei z. B. in DE 10 2004 036 035 A1 beschrieben.

Erfindungsgemäß können optional in der gitterartigen Struktur 14 großflächigere Bereiche belassen werden, unter denen somit nur eine schwache Porosifizierung, nämlich lediglich durch Ätzung von der Seite her erfolgt. Diese schwächer porosifizierten Bereiche können beim Tempern temporäre Stützstellen 30 in der Kaverne 26 ausbilden, die somit die Schicht 28 und die n-Epi-Schicht 24 oberhalb der Kaverne 26 abstützen.

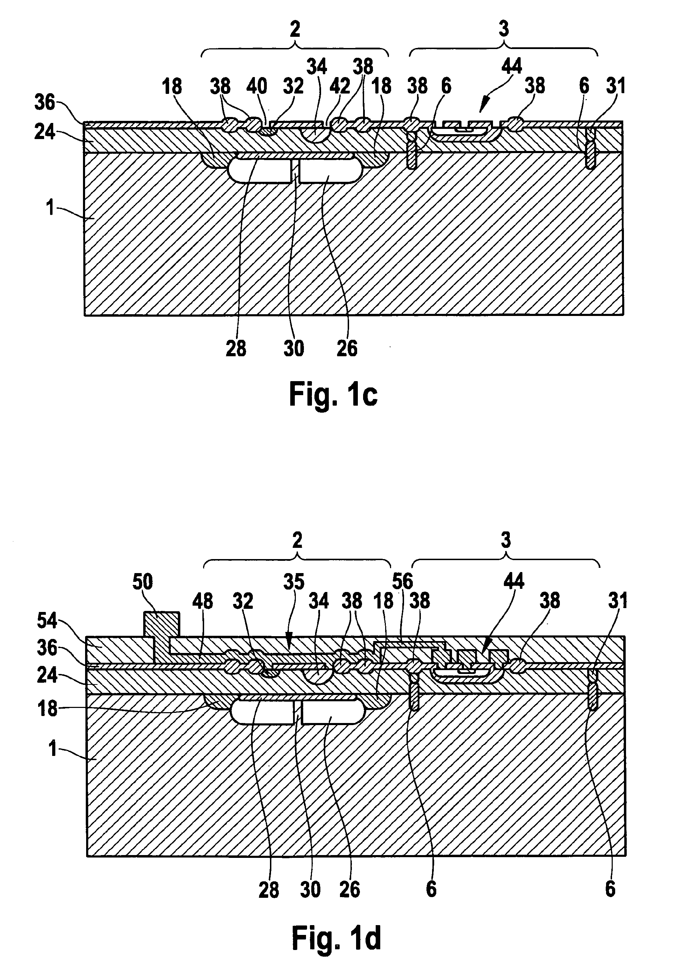

Nachfolgend werden gemäß Fig. 1c in und/oder auf der n-Epi-Schicht 24 geeignete Strukturen ausgebildet, was sowohl im Detektorbereich 2 als auch im Schaltungsbereich 3 durchgeführt werden kann. Im Schaltungsbereich 3 können in an sich bekannter Weise verschiedene Implantations- bzw. Diffusionsprozessschritte zur Ausbildung der Schaltungen angewendet werden. Im Detektorbereich 2 werden in der n-Epi-Schicht 24 für jedes spätere Pixel ein n⁺-Bereich 32 und ein p⁺-Bereich 34 durch Implantation und/oder Diffusion ausgebildet. Hierbei bilden die n-Epi-Schicht 24 mit dem p⁺-Bereich 34 eine Diode 35. Weiterhin werden eine oder mehrere dielektrische Schichten 36 ausgebildet, z. B. durch Oxidation zu SiO2, wobei zumindest im Detektorbereich 2 durch ein LOCOS-Verfahren lokal dickere LOCOS- Verstärkungsbereiche 38 ausgebildet werden. Hierzu wird in der SiO2-Schicht 36 durch geeignete Maskierung eine stärkere Oxidation mit entsprechender Volumenzunahme und somit Verdickung in vertikaler Richtung erreicht. Die LOCOS-Verstärkungsbereiche 38 werden insbesondere am Rand der späteren Pixel, d.h. oberhalb der Ränder der Kaverne 26 ausgebildet. Entsprechende LOCOS- Verstärkungsbereiche 38 können auch in dem Schaltungsbereich 3 ausgebildet werden.

Die eine oder mehreren dielektrischen Schichten 36 werden weiterhin im Schaltungsbereich 3 sowie im Detektorbereich 2 strukturiert. Hierbei werden oberhalb des n⁺-Bereichs 32 und des p⁺-Bereichs 34 Zugangslöcher 40, 42 für die spätere Kontaktierung strukturiert. Im Schaltungsbereich 3 werden z.B. verschiedene Bauelemente 44 strukturiert. Auch hier können LOCOS-Verstärkungen 38 ausgebildet werden.

Gemäß Fig. 1d werden in einem Backend-Schaltungsprozess Metallisierungen und Passivierungen, z.B. eine Metallisierungsschicht 48 mit Kontaktpad 50, und eine oder mehrere Passivierungsschichten 54 aufgetragen. Die Metallisierungsschicht 48 aus z. B. Al kontaktiert hierbei in den ausgesparten Zugangslöchern 40, 42 der dielektrischen Schicht 36 den n⁺-Bereich 32 und den p⁺-Bereich 34. Die Metallisierungsschicht 48 wird entsprechend auch im Schaltungsbereich 3 zur Kontaktierung der dort ausgebildeten Bauelemente 44, für Zuleitungen und gegebenenfalls auch für Bauelemente genutzt. Vorteilhafterweise werden durch die Metallisierungsschicht 48 auch Verbindungsleitungen 56 zwischen dem Detektorbereich 2 und dem Schaltungsbereich 3 ausgebildet, so dass ein integriertes Bauelement mit Detektorbereich 2 und Schaltungsbereich 3 ausgebildet wird.

Hierbei können eine oder mehrere Metallisierungsschichten 50 aus z.B. Al ausgebildet werden. Der n⁺-Bereich 32 dient lediglich der Kontaktierung mit der Metallisierungsschicht 50, damit zwischen dem Metall und dem hochdotiertem Bereich kein Schottky-Kontakt ausgebildet wird. Die eigentliche Diode 35 wird zwischen der n-Epi-Schicht 24 und dem p⁺-Bereich 34 ausgebildet, der aufgrund seiner hohen Dotierung ebenfalls keinen Schottky-Kontakt mit der Metallisierungsschicht 50 ausbildet. Wie Fig. 1d zu entnehmen ist, kann die n-Epi-Schicht 24 in lateraler Richtung durch eine obere Iso-Schicht 31 und oberhalb von dieser durch eine LOCOS-Verstärkung 38 von dem Schaltungsbereich 3 isoliert werden.

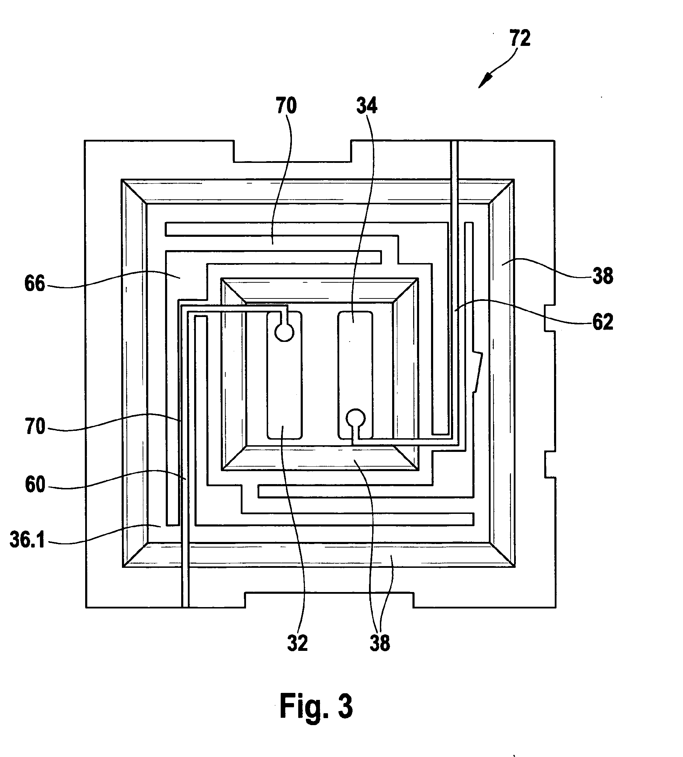

Die eine oder mehreren Metallisierungsschichten 48 dienen auch dazu, eine Ablagerung der ein oder mehreren Passivierungsschichten 54 oberhalb der Diode 35 zu verhindern. Die Passivierungsschicht 54 wird nachfolgend oberhalb der Diode 35 abgetragen, wobei die Metallisierungsschicht 48 als Ätzstopp dient. Nachfolgend wird die Metallisierungsschicht 48 oberhalb der Diode 35 in geeigneter Weise strukturiert, so dass lediglich der n⁺-Bereich 32 und p⁺-Bereich 34 durch Zuleitungen 60, 62 kontaktiert werden, wie in der Draufsicht der Fig. 3 ersichtlich ist (wobei die weitere Strukturierung der Fig. 3 erst nachfolgend ausgebildet wird).

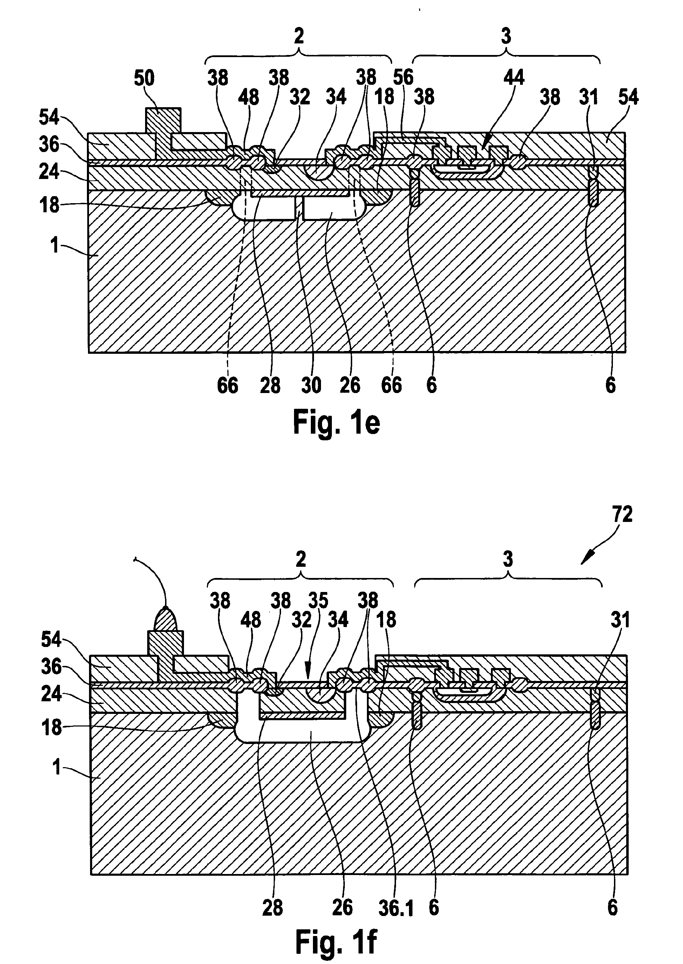

Gemäß Fig. 1e werden in der n-Epi-Schicht 24 weiterhin Opferschichtätzzugänge 66 geöffnet, vorzugsweise durch reaktives Ionenätzen durch die n-Epi-Schicht 24. Dies kann durch ein DRIE-Verfahren oder, da die n-Epi-Schicht z.B. nur wenige µm dick ist, ein herkömmliches reaktives Ionenätz-Verfahren, z.B. auch durch ein Bosch-Ätzverfahren, erfolgen. Hierbei werden Opferschichtätzzugänge 66 in der die vorläufige Membran bildenden n-Epi-Schicht 24 ausgebildet. Die Opferschichtätzzugänge 66 sind hierbei in der Draufsicht der Fig. 3 bereits ersichtlich, wobei allerdings die Zuleitungen 60, 62 noch nicht unterätzt sind. Dies erfolgt gemäß Fig. 1f in einem nachfolgendem isotropen Opferschichtätzschritt mit z.B. CIF3, XeF2 oder einem anderen Silizium selektiv ätzenden Ätzgas, bis der monokristalline Bereich des Diodenpixels 52 freigeätzt ist. Durch das Opferschichtätzen wird ein Teil der einen oder mehreren dielektrischen Schichten 36 unterätzt und somit als Membran 36.1 frei gelegt. Die strukturierte Membran 36.1 bildet hierbei elastische Aufhängefedern 70 aus, auf denen auch die Zuleitungen 60, 62 zu dem n⁺-Bereich 32 und dem p⁺-Bereich 34 verlaufen.

Falls gemäß Fig. 1b temporäre Stützstellen 30 ausgebildet waren, werden diese beim Unterätzen gemäß Fig. 1f mit entfernt.

Das Diodenpixel 52 wird somit durch die - z.B. vier - nunmehr frei hängenden Aufhängefedern 70 getragen, wobei die LOCOS-Verstärkungen 38 in den Aufhängefedern 70 bzw. am Übergang der Aufhängefedern 70 zum Festland ausgebildet sind. Somit sind die einzelnen Diodenpixel 52 über die Aufhängefedern 70 aus dem isolierenden SiO2 thermisch gut voneinander und von dem restlichen Material isoliert.

Das in Fig. 3 gezeigte Diodenpixel 52 kann insbesondere der direkten Temperatursensierung dienen. Ergänzend kann ein Absorptionsmaterial zur Absorption von IR-Strahlung auf das Diodenpixel 52 aufgetragen werden. Das genaue Design der LOCOS-Verstärkung 38 kann je nach der mechanischen Erfordernis erwählt werden, wobei gemäß der Draufsicht der Fig. 3 insbesondere eine ringförmige Verstärkung am inneren Ende der Aufhängefedern 70, d.h. am äußeren Rand des Diodenpixels 52, und am äußeren Ende der Aufhängefedern 70, d.h. bei der Anbindung am Festland, erfolgen kann. Somit werden zwei konzentrische, ringförmige bzw. rechteckige LOCOS-Verstärkungen 38 und 38 ausgebildet.

Fig. 1f sowie in Draufsicht Fig. 3 zeigen somit den fertigen Sensor 72, der im Allgemeinen mehrere Diodenpixel 52 und den Schaltungsbereich 3 mit einer geeigneten Auswerteschaltung aufweist.

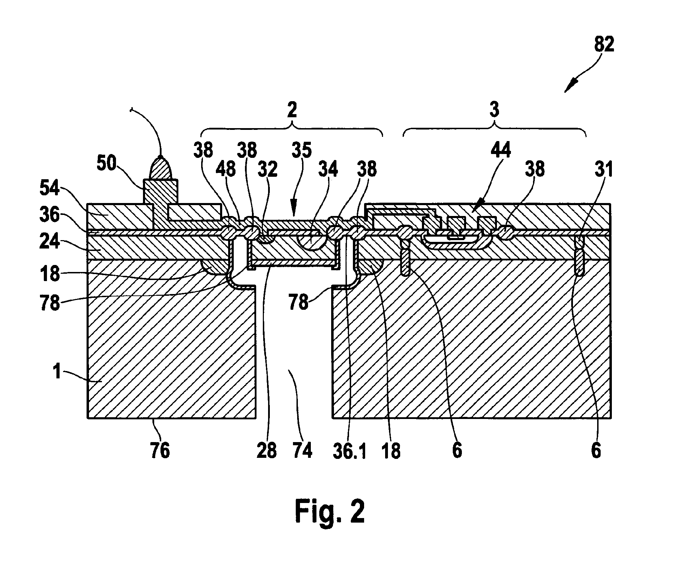

Bei der zu Fig. 1f alternativen Ausführungsform der Fig. 2 wird ergänzend von der Rückseite 76 des p-Substrates 1 bzw. des gesamten Wafers eine Kaverne 74 ausgebildet. Hierzu kann ein Bulk-Ätzverfahren von der Rückseite 76 des p-Substrates 1 her durchgeführt werden. Zum Schutz der Strukturen des Diodenpixels 52 kann von Fig. 1f ausgehend als erster Prozessschritt zunächst eine Oxidschicht 78 an den Grenzflächen sämtlicher Strukturen ausgebildet werden, d.h. am p-Substrat 1, der n-Epi-Schicht 24 sowohl im Festlandbereich als auch am Diodenpixel 52 und weiterhin am zweiten Bereich 18 mit n⁺-Dotierung. Diese Oxidation des Siliziums zu SiO2 kann somit zunächst von der Vorderseite her durchgeführt werden, woraufhin nachfolgend ein Tieftrench-Ätzprozess von der Rückseite 76 des p- Substrates 1 her durchgeführt wird und die Kaverne 74 ausgebildet wird, die somit unterhalb des betreffenden Diodenpixels 52 liegt.

Die Kaverne 74 kann nachfolgend mit einem geeignetem Material verschlossen werden, z.B. einem Material mit niedriger Wärmeleitfähigkeit λ. Der Sensor 82 der Fig. 2 entspricht somit bis auf die zusätzliche Kaverne 74 unterhalb der Diodenpixel 52 dem Sensor 72 aus Fig. 1f.

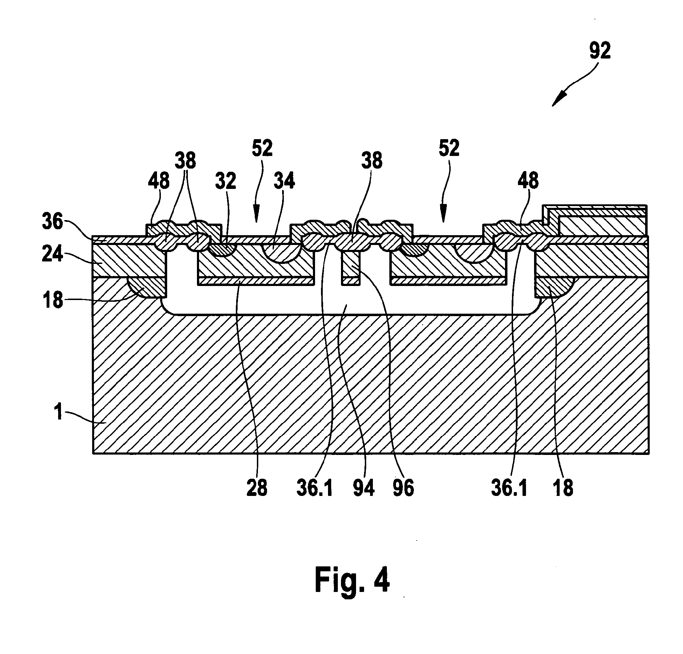

Fig. 4 zeigt eine weitere Ausführungsform eines Sensors 92, der grundsätzlich dem Sensor 72 der ersten Ausführungsform gemäß den Fig. 1f, 3 entspricht, wobei jedoch unterhalb der mehreren Diodenpixel 52 nicht mehrere getrennte Kavernen 26, sondern eine durchgängige Kaverne 94 ausgebildet ist, die somit sämtliche Diodenpixel 52 oder eine Anzahl Diodenpixel 52 umgibt. Somit entfällt gegenüber der ersten Ausführungsform die Abstützung der Membran 36.1 im p-Substrat 1. Hierbei sind allerdings zwischen den einzelnen Diodenpixeln 52 aus der n-Epi-Schicht 24 Stege 96 belassen und nicht weggeätzt, wobei diese Stege 96 bzw. die aus ihnen gebildete gitterartige Struktur der Wärmeabfuhr dient. Die mehreren Diodenpixel 52 heizen sich zunächst im Betrieb etwas auf, wobei die von ihnen erzeugte Wärme über die aus der dielektrischen Schicht 36 gebildete Membran 36.1 in lateraler Richtung an die Stege 96 abgegeben wird, wobei das Silizium-Material der Stege 96 eine hohe Wärmeleitfähigkeit aufweist. Somit kann die in den einzelnen Diodenpixeln 52 erzeugte Wärme nach außen in lateraler Richtung abgeführt werden. Bei der Ausführungsform der Fig. 4 wird somit eine einzige durchgängige Kaverne 94 erzeugt, an deren Unterseite die einzelnen Diodenpixel 52, die aus der n-Epi-Schicht 24 ausgebildet wurden sind, aufgehängt sind.

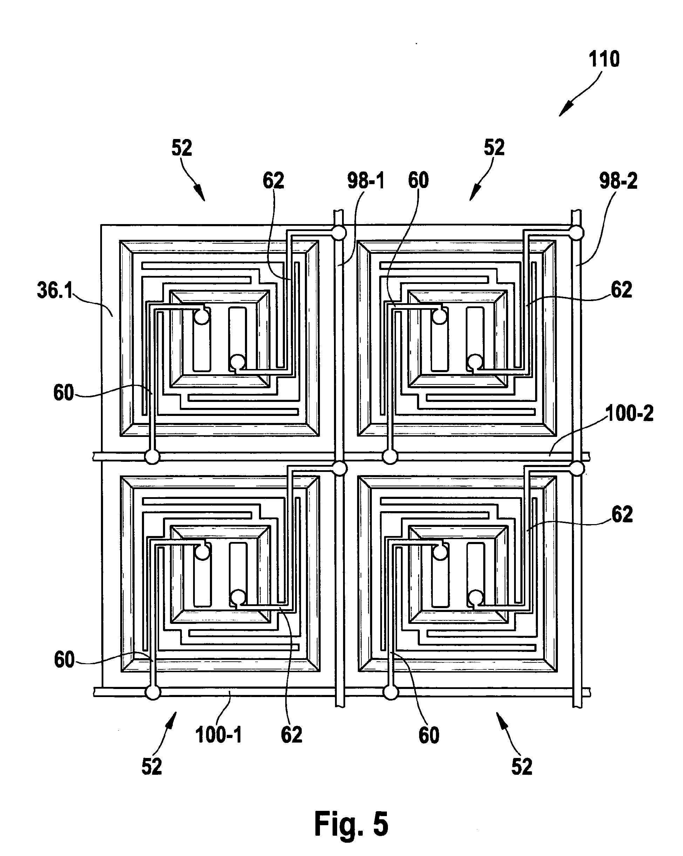

Fig. 5 zeigt eine Draufsicht auf ein Diodenarray aus vier Diodenpixeln 52. Die Zuleitungen 60, 62 jedes Diodenpixels 52 können an gemeinsame Zuleitungen 98, 100 angeschlossen werden; somit sind die den jeweiligen n⁺-Bereich 32 kontaktierenden (Kathoden-) Zuleitungen 60 an eine gemeinsame Kathoden-Zuleitungen 100-1, 100-2, .. angeschlossen und die den jeweiligen p⁺-Bereich 34 kontaktierenden (Anoden-) Zuleitungen 62 an ein oder mehrere gemeinsame Anoden- Zuleitungen 98-1, 98-2..... angeschlossen. Somit können die einzelnen Diodenpixel 52 über die entsprechende Adressierung der gemeinsamen Zuleitungen 98-1, 98-2,... sowie jeweils 100-1, 100-2 ausgelesen werden.

Bei einer derartigen Anordnung kann somit ein komplexes Diodenarray 110 mit relativ wenigen Zuleitungen ausgebildet werden. Die gemeinsamen Zuleitungen 98-1, 98-2,..., 100-1, 100-2,... können bei Ausbildung einer größeren Kaverne 94 gemäß Fig. 4 auf der Membran 36.1 oberhalb der Stege 96 aufgetragen werden, wobei an den Kreuzungspunkten der Zuleitungen 98-1, 98-2,..., 100-1, 100-2,... eine Kontaktierung durch eine entsprechende Isolationsschicht verhindert wird.

## Patentansprüche

1. Sensor, der aufweist:
- ein Substrat (1),
- mindestens ein mikrostrukturiertes Sensorelement (52) mit einer ihren Wert temperaturabhängig ändernden, elektrischen Eigenschaft, und
- mindestens eine Membran (36.1) oberhalb einer Kaverne (26, 74, 94),
wobei das mindestens eine Sensorelement (52) an der Unterseite der mindestens einen Membran (36.1) angeordnet ist, und
wobei das Sensorelement (52) über Zuleitungen (60, 62; 98-1, 98-2, 100-1, 100-2) kontaktiert ist, die in, auf oder unter der Membran (36.1) verlaufen,
wobei das mindestens eine mikrostrukturierte Sensorelement (52) eine an der Unterseite der Membran (36.1) ausgebildete monokristalline Schicht (24) mit mindestens einem pn-Übergang zwischen einem positiv dotierten Bereich (34) und einem negativ dotierten Bereich (24) aufweist,
**dadurch gekennzeichnet, dass** der Sensor mehrere mikrostrukturierte Sensorelemente (52) umfasst, welche als Diodenpixel (52) ausgebildet sind.

2. Sensor nach Anspruch 1, **dadurch gekennzeichnet, dass** das Sensorelement (52) jeweils einen mit einer ersten Zuleitung (60) kontaktierten n⁺-dotierten Bereich (32) und einen mit einer zweiten Zuleitung (62) kontaktierten p⁺- dotierten Bereich (34) aufweist, die in der dotierten monokristallinen Schicht (24) ausgebildet sind.

3. Sensor nach einem der vorherigen Ansprüche, **dadurch gekennzeichnet, dass** die Membran (36.1) als Teilbereich einer oder mehrerer dielektrischer Schichten (36) ausgebildet ist.

4. Sensor nach einem der vorherigen Ansprüche, **dadurch gekennzeichnet, dass** die Membran (36.1) eine Oxidschicht (36) aufweist, in der durch lokale Oxidation Verstärkungen (38) ausgebildet sind.

5. Sensor nach Anspruch 4, **dadurch gekennzeichnet, dass** die Verstärkungen (38) am lateralen Rand des Sensorelementes (52) und/oder am lateralen Rand des die Kaverne (26, 74, 94) umgebenen Festlandes (24) und/oder am lateralen Rand von zwischen den Sensorelementen (52) verlaufenden Stegen ausgebildet sind.

6. Sensor nach einem der vorherigen Ansprüche, **dadurch gekennzeichnet, dass** in der Membran Aufhängefedern (70) als stegartige Bereiche ausgebildet sind, und das mindestens eine Sensorelement (52) an den Aufhängefedern (70) aufgehängt ist.

7. Sensor nach Anspruch 6, **dadurch gekennzeichnet, dass** die Zuleitung (60, 62) zu dem Sensorelement (52) auf, in oder unter den Aufhängefedern (70) verlaufen.

8. Sensor nach einem der vorherigen Ansprüche, **dadurch gekennzeichnet, dass** die Kaverne (26, 94) im Substrat (1) ausgebildet ist und nach unten begrenzt ist.

9. Sensor nach einem der Ansprüche 1 bis 9, **dadurch gekennzeichnet, dass** die Kaverne (74) sich bis zur Rückseite (76) des Substrates (1) erstreckt.

10. Sensor nach einem der vorherigen Ansprüche, **dadurch gekennzeichnet, dass** unter mehreren oder allen Sensorelementen (52) eine gemeinsame Kaverne (94) ausgebildet ist.

11. Sensor nach einem der vorherigen Ansprüche, **dadurch gekennzeichnet, dass** mehrere Sensorelemente (52) vorgesehen sind und die Zuleitungen (60, 62) jedes Sensorelementes (52) an gemeinsame Zuleitungen (98-1, 98-2, 100-1, 100-2) kontaktiert sind und jedes Sensorelement (52) durch Adressierung oder Auslesen jeweils eines Paares von gemeinsamen Zuleitungen (98-1, 98-2, 100-1, 100-2) sukzessive auslesbar ist.

12. Sensor nach einem der vorherigen Ansprüche, **dadurch gekennzeichnet, dass** auf dem Substrat (1) ein Detektorbereich (2) mit dem mindestens einen mikrostrukturierten elektrischen Sensorelement (52) und ein Schaltungsbereich (3) mit Bauelementen (44) zur Aufnahme und Verarbeitung des von dem mindestens einen Sensorelement (52) des Detektorbereichs (2) ausgegebenen Messsignalen (S1) ausgebildet ist.

13. Sensor nach Anspruch 12, **dadurch gekennzeichnet, dass** der Detektorbereich (2) und der Schaltungsbereich (3) in zumindest teilweise denselben Schichten (24, 48, 54) ausgebildet sind.

14. Sensor nach einem der vorherigen Ansprüche, **dadurch gekennzeichnet, dass** er ein Sensor (120) zur ortsaufgelösten Detektion, insbesondere zur ortsaufgelösten Messung von Temperatur und/oder Strahlung und/oder eines Fingerabdruckes, oder ein Sensor zur Detektion einer Gaskonzentration ist.

15. Verfahren zum Herstellen eines Sensors (120), insbesondere eines Sensors nach einem der vorherigen Ansprüche, der mehrere als Diodenpixel ausgebildete mikrostrukturierte Sensorelement (52) aufweist, wobei mindestens eines der Sensorelemente eine seinen Wert temperaturabhängig ändernden elektrischen Eigenschaft aufweist,
wobei zur Herstellung des Sensors mindestens folgenden Schritten durchgeführt werden:
a) Ausbilden einer gitterartigen Struktur (14) auf einer Oberseite des Substrates (1) oder einer auf dem Substrat (1) ausgebildeten Schicht,
b) elektrochemisches Ätzen eines ersten Bereichs (12) unterhalb der gitterartigen Struktur (14) unter Ausbildung porösen Materials oder eines Freiraums,
c) Auftragen einer epitaktischen Schicht (24) auf das Substrat (1) oder eine das Substrat (1) bedeckenden Schicht,
wobei die epitaktische Schicht (24) auch auf der gitterartigen Struktur (14) ganzflächig ausgebildet wird und der erste Bereich (12) unterhalb der gitterartigen Struktur (14) eine Kaverne (26, 74, 94) ausbildet,
d) Ausbilden des mindestens einen Sensorelementes (52) in oder auf der epitaktischen Schicht (24),
e) Auftragen mindestens einer dielektrischen Schicht (36) auf die epitaktische Schicht (24) vor, während oder nach der Strukturierung der epitaktischen Schicht (24),
f) Kontaktieren des Sensorelementes (52) über in ein oder mehreren leitfähigen Schichten (48) ausgebildete Zuleitungen (60, 62),
g) Freilegen von Ätzzugängen (66) durch die mindestens eine dielektrische Schicht (36) und die epitaktische Schicht (24) zu jeder Kaverne (26, 74, 94), wobei die mindestens eine dielektrische Schicht (36) derartig strukturiert wird, dass die Zuleitungen (60, 62) auf verbleibenden Bereichen der dielektrischen Schicht (36) verlaufen,
h) Opferschichtätzen der epitaktischen Schicht (24) und Freilegung der mindestens einen dielektrischen Schicht (36) um das mindestens eine Sensorelement (52) herum als Membran (36.1).

16. Verfahren nach Anspruch 15, **dadurch gekennzeichnet, dass**
in Schritt a) zunächst ein den ersten Bereich (12) umgebender zweiter Bereich (18) von einem gegenüber dem ersten Bereich (12) entgegengesetzten Ladungsträgertyp ausgebildet wird,
in Schritt b) der erste Bereich (12) durch einen elektrolytischen Ätzprozess porosifiziert oder ganz entfernt wird unter Beibehaltung des zweiten Bereichs (18) als laterale Begrenzung, und
falls der erste Bereich (12) in Schritt b) porosifiziert und unvollständig entfernt wird, in Schritt c) eine Temperung des ersten Bereichs (12) zur Erzeugung der Kaverne (26, 94) unterhalb der epitaktischen Schicht (24) erfolgt.

17. Verfahren nach Anspruch 15 oder 16, **dadurch gekennzeichnet, dass** die mindestens eine dielektrische Schicht (36) als Oxid auf der epitaktischen Schicht (24) ausgebildet wird,
wobei in der mindestens einen dielektrischen Schicht (36) im Bereich der späteren Membran (36.1) durch lokale Oxidation Verstärkungen (38) mit größerer Dicke zur Erhöhung der mechanischen Stabilität ausgebildet werden.

18. Verfahren nach Anspruch 17, **dadurch gekennzeichnet, dass** die Verstärkungen (38) am lateralen Rand der Sensorelemente (52) und/oder am lateralen Rand des die Sensorelemente (52) umgebenden Festlandes und/oder am lateralen Rand eines die Sensorelemente (52) umgebenden Gitters aus Stegen umlaufend ausgebildet werden.

19. Verfahren nach einem der Ansprüche 16 bis 18, **dadurch gekennzeichnet, dass** ergänzend von der Rückseite (76) des Substrates (1) her eine Kaverne (74) bis zu der unterhalb der epitaktischen Schicht (24) ausgebildeten Kaverne (26, 94) ausgebildet wird.

20. Verfahren nach einem der Ansprüche 15 bis 18, **dadurch gekennzeichnet, dass** in einem Schaltungsbereich (3) des Sensors (120) ein oder mehrere Bauelemente (44) ausgebildet werden, wobei zumindest einige Prozessschritte der Ausbildung der Sensorelemente (52) des Detektorbereichs (2) auch zur Ausbildung des Schaltungsbereichs (3) verwendet werden.

## Claims

1. Sensor, comprising:
- a substrate (1),
- at least one microstructured sensor element (52) having an electrical property that changes its value in a temperature-dependent manner, and
- at least one membrane (36.1) above a cavity (26, 74, 94),
wherein the at least one sensor element (52) is arranged at the underside of the at least one membrane (36.1), and
wherein the sensor element (52) is contact-connected via leads (60, 62; 98-1, 98-2, 100-1, 100-2) running in, on or under the membrane (36.1),
wherein the at least one microstructured sensor element (52) has a monocrystalline layer (24) formed at the underside of the membrane (36.1) and having at least one pn junction between a positively doped region (34) and a negatively doped region (24),
**characterized in that** the sensor comprises a plurality of microstructured sensor elements (52) embodied as diode pixels (52).

2. Sensor according to Claim 1, **characterized in that** the sensor element (52) has in each case an n⁺-doped region (32) contact-connected to a first lead (60) and a p⁺-doped region (34) contact-connected to a second lead (62), which are formed in the doped monocrystalline layer (24).

3. Sensor according to either of the preceding claims, **characterized in that** the membrane (36.1) is formed as a partial region of one or more dielectric layers (36).

4. Sensor according to any of the preceding claims, **characterized in that** the membrane (36.1) has an oxide layer (36), in which reinforcements (38) are formed by local oxidation.

5. Sensor according to Claim 4, **characterized in that** the reinforcements (38) are formed at the lateral edge of the sensor element (52) and/or at the lateral edge of the solid land (24) surrounding the cavity (26, 74, 94) and/or at the lateral edge of webs running between the sensor elements (52).

6. Sensor according to any of the preceding claims, **characterized in that** suspension springs (70) are formed as web-like regions in the membrane, and the at least one sensor element (52) is suspended on the suspension springs (70).

7. Sensor according to Claim 6, **characterized in that** the leads (60, 62) to the sensor element (52) run on, in or under the suspension springs (70).

8. Sensor according to any of the preceding claims, **characterized in that** the cavity (26, 94) is formed in the substrate (1) and is delimited towards the bottom.

9. Sensor according to any of Claims 1 to 9, **characterized in that** the cavity (74) extends as far as the rear side (76) of the substrate (1).

10. Sensor according to any of the preceding claims, **characterized in that** a common cavity (94) is formed under a plurality or all of the sensor elements (52).

11. Sensor according to any of the preceding claims, **characterized in that** a plurality of sensor elements (52) are provided and the leads (60, 62) of each sensor element (52) are contact-connected to common leads (98-1, 98-2, 100-1, 100-2) and each sensor element (52) can be read successively by the addressing or read-out of a respective pair of common leads (98-1, 98-2, 100-1, 100-2).

12. Sensor according to any of the preceding claims, **characterized in that** a detector region (2) having the at least one microstructured electrical sensor element (52) and a circuit region (3) having components (44) for picking up and processing the measurement signals (S1) output by the at least one sensor element (52) of the detector region (2) are formed on the substrate (1).

13. Sensor according to Claim 12, **characterized in that** the detector region (2) and the circuit region (3) are formed in at least partly the same layers (24, 48, 54).

14. Sensor according to any of the preceding claims, **characterized in that** it is a sensor (120) for spatially resolved detection, in particular for spatially resolved measurement of temperature and/or radiation and/or a fingerprint, or a sensor for detection of a gas concentration.

15. Method for producing a sensor (120), more particularly a sensor according to any of the preceding claims, which comprises a plurality of microstructured sensor elements (52) embodied as diode pixels, wherein at least one of the sensor elements has an electrical property that changes its value in a temperature-dependent manner,
wherein at least the following steps are carried out for producing the sensor:
a) forming a lattice-like structure (14) on a top side of the substrate (1) or a layer formed on the substrate (1),
b) electrochemically etching a first region (12) below the lattice-like structure (14) to form porous material or a free space,
c) applying an epitaxial layer (24) to the substrate (1) or a layer covering the substrate (1),
wherein the epitaxial layer (24) is also formed over the whole area on the lattice-like structure (14) and the first region (12) below the lattice-like structure (14) forms a cavity (26, 74, 94),
d) forming the at least one sensor element (52) in or on the epitaxial layer (24),
e) applying at least one dielectric layer (36) to the epitaxial layer (24) before, during or after the structuring of the epitaxial layer (24),
f) making contact with the sensor element (52) via leads (60, 62) formed in one or a plurality of conductive layers (48),
g) uncovering etching accesses (66) through the at least one dielectric layer (36) and the epitaxial layer (24) to each cavity (26, 74, 94), wherein the at least one dielectric layer (36) is structured in such a way that the leads (60, 62) run on remaining regions of the dielectric layer (36),
h) sacrificial layer etching of the epitaxial layer (24) and uncovering of the at least one dielectric layer (36) around the at least one sensor element (52) as membrane (36.1).

16. Method according to claim 15, **characterized in that**
in step a) firstly a second region (18) surrounding the first region (12) is formed, said second region being of an opposite charge carrier type relative to the first region (12),
in step b) the first region (12) is porocified or completely removed by an electrolytic etching process, whilst maintaining the second region (18) as lateral delimitation, and
if the first region (12) is porocified and removed incompletely in step b), in step c) the first region (12) is subjected to heat treatment in order to produce the cavity (26, 94) below the epitaxial layer (24).

17. Method according to Claim 15 or 16, **characterized in that** the at least one dielectric layer (36) is formed as oxide on the epitaxial layer (24),
wherein reinforcements (38) having a larger thickness in order to increase the mechanical stability are formed in the at least one dielectric layer (36) in the region of the later membrane (36.1) by local oxidation.

18. Method according to Claim 17, **characterized in that** the reinforcements (38) are formed circumferentially at the lateral edge of the sensor elements (52) and/or at the lateral edge of the solid land surrounding the sensor element (52) and/or at the lateral edge of a lattice composed of webs that surrounds the sensor elements (52).

19. Method according to any of Claims 16 to 18, **characterized in that** supplementarily from the rear side (76) of the substrate (1) a cavity (74) is formed as far as the cavity (26, 94) formed below the epitaxial layer (24).

20. Method according to any of Claims 15 to 18, **characterized in that** one or more components (44) are formed in a circuit region (3) of the sensor (120), wherein at least some process steps of the formation of the sensor elements (52) of the detector region (2) are also used for the formation of the circuit region (3).

## Revendications

1. Capteur comportant :
- un substrat (1) ;
- au moins un élément de capteur (52) à microstructure avec une propriété électrique dont la valeur varie en fonction de la température ; et
- au moins une membrane (36.1) placée au-dessus d'une excavation (26, 74, 94) ;
l'au moins un élément de capteur (52) étant disposé au niveau du côté inférieur de l'au moins une membrane (36.1) ; et
l'élément de capteur (52) étant mis en contact par le biais de conduites d'amenée (60, 62 ; 98-1, 98-2, 100-1, 100-2) s'étendant dans, sur ou sous la membrane (36.1) ;
l'au moins un élément de capteur (52) à microstructure comportant une couche monocristalline (24) réalisée au niveau du côté inférieur de la membrane (36.1) et dotée d'au moins une transition pn entre une zone de dotation positive (34) et une zone de dotation négative (24) ; **caractérisé en ce que** le capteur comprend plusieurs éléments de capteur (52) à microstructure prenant la forme de pixels à diodes (52).

2. Capteur selon la revendication 1, **caractérisé en ce que** l'élément de capteur (52) comporte respectivement une zone dotée n⁺ (32) mise en contact avec une première conduite d'amenée (60) et une zone dotée p⁺ (34) mise en contact avec une deuxième conduite d'amenée (62) réalisée dans la couche monocristalline (24) dotée.

3. Capteur selon l'une quelconque des revendications précédentes, **caractérisé en ce que** la membrane (36.1) prend la forme d'une zone partielle d'une ou de plusieurs couches diélectriques (36).

4. Capteur selon l'une quelconque des revendications précédentes, **caractérisé en ce que** la membrane (36.1) comporte une couche d'oxyde (36) dans laquelle des renforts (38) sont réalisés par oxydation locale.

5. Capteur selon la revendication 4, **caractérisé en ce que** les renforts (38) sont réalisés au niveau du bord latéral de l'élément de capteur (52) et/ou au niveau du bord latéral de la zone fixe (24) entourant l'excavation (26, 74, 94) et/ou au niveau du bord des étais s'étendant entre les éléments de capteur (52).

6. Capteur selon l'une quelconque des revendications précédentes, **caractérisé en ce que** les ressorts de suspension (70) prévus dans la membrane prennent la forme de zones de type étai et **en ce que** l'au moins un élément de capteur (52) est suspendu au niveau des ressorts de suspension (70).

7. Capteur selon la revendication 6, **caractérisé en ce que** les conduites d'amenée (60, 62) s'étendent sur, dans ou sous les ressorts de suspension (70) par rapport à l'élément de capteur (52).

8. Capteur selon l'une quelconque des revendications précédentes, **caractérisé en ce que** l'excavation (26, 94) est réalisée dans le substrat (1) et délimitée vers le bas.

9. Capteur selon l'une quelconque des revendications 1 à 9, **caractérisé en ce que** l'excavation (74) s'étend jusque sur l'arrière (76) du substrat (1).

10. Capteur selon l'une quelconque des revendications précédentes, **caractérisé en ce qu'**une excavation (94) commune est réalisée sous plusieurs ou tous les éléments de capteur (52).

11. Capteur selon l'une quelconque des revendications précédentes, **caractérisé en ce que** plusieurs éléments de capteur (52) sont prévus et **en ce que** les conduites d'amenée (60, 62) de chaque élément de capteur (52) sont mises en contact au niveau des conduites d'amenée (98-1, 98-2, 100-1, 100-2) communes et **en ce que** chaque élément de capteur (52) peut être sélectionné de façon sélective par adressage ou sélection respective d'une paire de conduites d'amenée (98-1, 98-2, 100-1, 100-2) commune.

12. Capteur selon l'une quelconque des revendications précédentes, **caractérisé en ce qu'**une zone de détection (2) est réalisée sur le substrat (1) avec l'au moins un élément de capteur électrique (52) à microstructure ainsi qu'une zone de connexion (3) dotée de composants (44) pour recevoir et traiter les signaux de mesure (S1) provenant de l'au moins un élément de capteur (52) de la zone de détection (2).

13. Capteur selon la revendication 12, **caractérisé en ce que** la zone de détection (2) et la zone de connexion (3) sont réalisées au moins en partie dans les mêmes couches (24, 48, 54).

14. Capteur selon l'une quelconque des revendications précédentes, **caractérisé en ce que** ledit capteur est soit un capteur (120) permettant une détection localisée, notamment pour mesurer de façon localisée la température et/ou le rayonnement et/ou une pression du doigt, soit un capteur de détection d'une concentration de gaz.

15. Procédé de fabrication d'un capteur (120), notamment d'un capteur selon l'une quelconque des revendications précédentes, qui comporte plusieurs éléments de capteur (52) à microstructure prenant la forme de pixels à diodes, au moins un des éléments de capteur présentant une propriété électrique dont la valeur varie en fonction de la température ;
la fabrication du capteur requérant au moins la réalisation des étapes suivantes :
a) formation d'une structure (14) grillagée sur un côté supérieur du substrat (1) ou d'une couche réalisée sur le substrat (1) ;
b) gravure électrochimique d'une première zone (12) située en dessous de la structure (14) grillagée permettant de former un matériau poreux ou un espace libre ;
c) application d'une couche (24) épitaxique sur le substrat (1) ou d'une couche recouvrant le substrat (1) ;
la couche (24) épitaxique étant également réalisée sur l'ensemble de la surface de la structure (14) grillagée et la première zone (12) formant une excavation (26, 74, 94) en dessous de la structure (14) grillagée ;
d) formation de l'au moins un élément de capteur (52) dans ou sur la couche (24) épitaxique ;
e) application d'au moins une couche (36) diélectrique sur la couche (24) épitaxique avant, pendant ou après la structuration de la couche (24) épitaxique ;
f) mise en contact de l'élément de capteur (52) via des conduites d'amenée (60, 62) réalisées dans une ou plusieurs couches (48) conductrices ;
g) dégagement des accès aux gravures (66) à travers l'au moins une couche (36) diélectrique et la couche (24) épitaxique permettant d'accéder à chaque excavation (26, 74, 94), l'au moins une couche diélectrique (36) étant structurée de telle sorte que les conduites d'amenée (60, 62) s'étendent sur les zones restantes de la couche diélectrique (36) ;
h) gravure par couche sacrificielle de la couche (24) épitaxique et dégagement de l'au moins une couche diélectrique (36) autour de l'au moins un élément de capteur (52) tout autour de la membrane (36.1).

16. Procédé selon la revendication 15, **caractérisé en ce que** :
à l'étape a), une deuxième zone (18) entourant la première zone (12) est d'abord réalisée par un type d'accumulation de porteurs de charge opposé par rapport à la première zone (12) ;
à l'étape b), la première zone (12) est rendue poreuse ou est intégralement retirée au moyen d'un processus de gravure électrolytique en conservant la deuxième zone (18) comme délimitation latérale ; et
si la première zone (12) est rendue poreuse et non intégralement retirée à l'étape b), à l'étape c), un malaxage de la première zone (12) est effectué pour réaliser l'excavation (26, 94) en dessous de la couche (24) épitaxique.

17. Procédé selon la revendication 15 ou 16, **caractérisé en ce que** l'au moins une couche diélectrique (36) prend la forme d'un oxyde placé sur la couche (24) épitaxique ;
des renforts (38) d'épaisseur plus importante étant réalisés dans l'au moins une couche diélectrique (36), dans la zone de la future membrane (36.1), par oxydation locale, pour accroître la stabilité mécanique.

18. Procédé selon la revendication 17, **caractérisé en ce que** les renforts (38) sont réalisés de façon périphérique au niveau du bord latéral des éléments de capteur (52) et/ou au niveau du bord latéral de la zone fixe entourant les éléments de capteur (52) et/ou au niveau du bord latéral d'un grillage constitué d'étais entourant les éléments de capteur (52).

19. Procédé selon l'une quelconque des revendications 16 à 18, **caractérisé en ce qu'**en complément, une excavation (74) est réalisée depuis l'arrière (76) du substrat (1) jusqu'à l'excavation (26, 94) réalisée en dessous de la couche (24) épitaxique.

20. Procédé selon l'une quelconque des revendications 15 à 18, **caractérisé en ce qu'**un ou plusieurs composants (44) sont réalisés dans une zone de connexion (3) du capteur (120), au moins quelques étapes de procédé de la formation des éléments de capteur (52) de la zone de détection (2) servant également à la formation de la zone de connexion (3).
